Europäisches Patentamt

European Patent Office

Office européen des brevets

(19)

(11) Publication number: 0 520 675 A2

# EUROPEAN PATENT APPLICATION

(12)

(21) Application number: 92305539.6

(22) Date of filing: 17.06.92

(51) Int. Cl.5: **H03K 5/15**

(30) Priority: 28.06.91 US 724391

(43) Date of publication of application:
30.12.92 Bulletin 92/53

(84) Designated Contracting States:
DE FR GB IT

(71) Applicant: SGS-THOMSON
MICROELECTRONICS, INC.
1310 Electronics Drive
Carrollton Texas 75006(US)

(72) Inventor: King, Kevin Paul
16820 East Campbell Road
Gilbert, Arizona 85234(US)
Inventor: Raasch, Randy Wayne
7823 E. Via De La Entrada
Scottsdale, Arizona 85258(US)

(74) Representative: Palmer, Roger et al
PAGE, WHITE & FARRER 54 Doughty Street
London WC1N 2LS(GB)

(54) Flushable delay line.

(57) A delay line generates a sequence of outputs which change state at known intervals after a state change in a single clock input. These outputs are suitable for driving various types of microcontrollers which need accurately timed delay signals. A separate reset input is provided, and is capable of being connected to each of the delay elements within the delay line individually. This allows the entire delay line to be reset to a known state in a short period of time. As a result, each new clock cycle which is applied to the delay line always begins with the delay line reset to such known state. This eliminates the necessity for external logic to be used to determine whether an output signal is valid as belonging to the current clock cycle.

FIG. 3

The present invention relates generally to electronic circuits, and more specifically to a technique for resetting delay line timing circuits such as may be found in control devices.

Many types of digital electronic circuits, such as memory controllers and programmable microcontrollers, require the generation of precisely timed signals. Typically, a delay line circuit is used to generate a sequence of timed signals in response to a change in state of a clock signal.

After a clock signal is input into a delay line, various output signals change state in a timed sequence. The output signals are often referred to as tap signals from the delay line. These signals can be used to provide various timing controls for various purposes.

One problem encountered in prior art delay line integrated circuit devices is the result of the fact that the accurate delay line truly generates delays of the input signal. Thus, when a new clock cycle begins, the state changes caused by the previous clock cycle have typically not yet completed passing through the delay line. This means that at the beginning of a new clock cycle, the delay line has not been completely reset to a known state. Since the timing of following clock cycles cannot be predicted accurately ahead of time, it is necessary to provide additional circuitry to ensure that the controller which makes use of the timing signals does not operate incorrectly as a result. The required extra circuitry adds complexity and cost to delay lines which have heretofore been available.

It would therefore be desirable to provide a delay line circuit, suitable for integration into an integrated circuit device, which provides improved operation over prior art devices. Such delay line preferably has a plurality of taps which generate output signals suitable for driving other devices. Such an improved device is preferably capable of being completely reset to a known state in a short period of time, so that each clock cycle will be applied to the delay line with outputs thereof completely reset.

Therefore, according to the present invention, a delay line generates a sequence of outputs which change state at known intervals after a state change in a single clock input. These outputs are suitable for driving various types of microcontrollers which need accurately timed delay signals. A separate reset input is provided, and is capable of being connected to each of the delay elements within the delay line individually. This allows the entire delay line to be reset to a known state in a short period of time. As a result, each new clock cycle which is applied to the delay line always begins with the delay line reset to such known state. This eliminates the necessity for external logic to be used to determine whether an output signal is valid as belonging to the current clock cycle.

The novel features believed characteristic of the invention are set forth in the appended claims. The invention itself however, as well as a preferred mode of use, and further objects and advantages thereof, will best be understood by reference to the following detailed description of an illustrative embodiment when read in conjunction with the accompanying drawings, wherein:

**Figure 1** is a block diagram of a delay line according to the prior art;

**Figure 2** is a timing diagram used in conjunction with the block diagram of **Figure 1**;

**Figure 3** is a logic block diagram of a portion of a preferred delay line according to the present invention;

**Figure 4** is a timing diagram illustrating the function of a preferred delay line; and

**Figure 5** is a logic diagram indicating an alternative embodiment of a preferred delay line circuit incorporating a completion output signal.

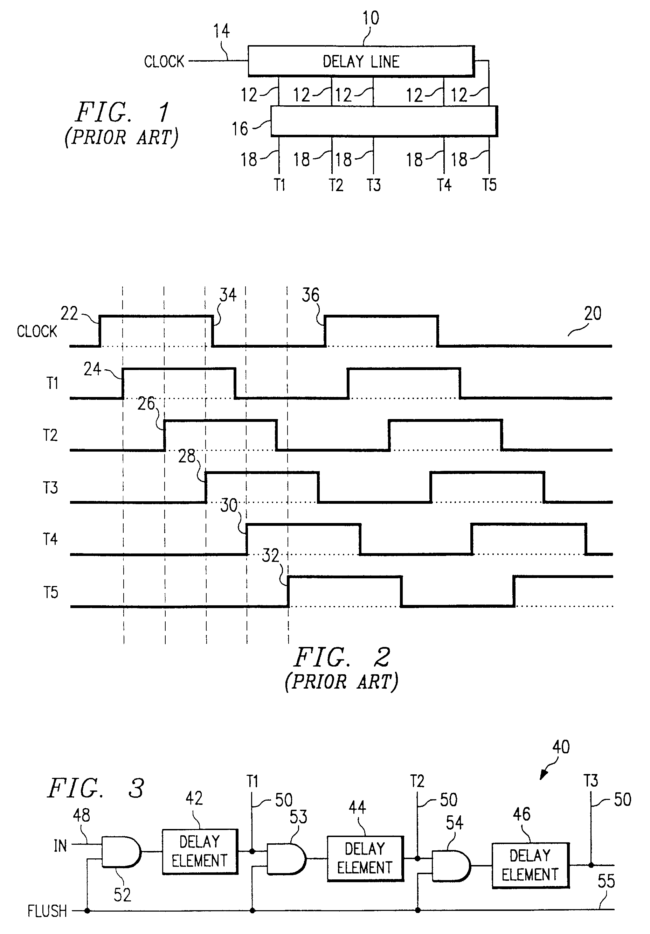

Referring to **Figure 1**, a delay line is shown which functions in accordance with principles used in the prior art. A delay line **10** has a plurality of outputs **12**. The outputs **12** are often referred to in the art as "taps", with each output being activated a predetermined, accurate delay period after a change in state of a signal applied to an input line **14**. The outputs **12** are connected to logic circuitry **16**, which in turn generates tap output signals on lines **18**. In the circuit shown in **Figure 1**, five tap output signals T1, T2, T3, T4, and T5, are shown, although the number of taps which may be generated will depend upon the requirements of the controller for which the delay line **10** is being designed. Actual construction of the delay line is well known in the art.

The timing diagram of Figure 2 illustrates why the logic circuitry **16** is necessary. A clock signal **20** is presumed to be active high. When the clock signal **20** goes high at transition **22** to begin a clock cycle, the signal feeds into the input line **14** of delay line **10**. After a first delay period, determined by the interior delays preset into delay line **10**, the first tap output signal T1 also goes high as shown by transition **24**. The remaining tap output signals T2 through T5 go high after their respective delay periods as indicated by transitions **26 - 32**. Eventually, the clock goes low as shown by transition **34**, and a new clock cycle begins with the clock transitioning high as shown by transition **36**. The precise relationship between the timing of the transition **34** and the transitions of tap outputs depends on the duty cycle of the clock and the delays of the stages in the delay line.

For purposes of this example, the duty cycle of the clock is such that the outputs of taps T1, T2, and T3 return low before the next clock cycle begins at transition **36**. However, the outputs of taps T4 and T5 are still high when the transition **36** occurs at the beginning of the next clock cycle, since the low value of the clock after transition **34** has not yet been transmitted through the entire delay line **10**. This means that, as of the start of the clock cycle initiated by transition **36**, the delay line is not in a known state. Since, in many systems, the delay between transition **34** and transition **36** is indeterminate in advance, and can change from time to time, the state of all the outputs T1 - T5 cannot be guaranteed at the beginning of each clock cycle.

One way to get around this problem is simply to provide for a minimum delay between the transitions **34** and **36**. This delay is long enough to ensure that the entire delay line **10** resets to a known state. Such requirement can significantly decrease system performance, since the clock must be delayed by an amount sufficient to ensure that the entire delay line resets.

Another approach is to provide the logic circuitry **16** shown in **Figure 1**. This logic circuitry typically also has as an input (not shown) the clock signal. Sequential logic circuitry contained in block **16** allows for discrimination of signals which occur before and after the beginning of a clock cycle. Thus, when a clock cycle completes the logic circuitry **16** takes this into account so that the controller making use of timing signals T1 - T5 is not confused. This allows a new clock cycle to begin on input line **14** while the trailing edge of the old clock cycle is still traveling through the delay line **10**.

A preferred embodiment of a delay line according to the present invention is shown in **Figure 3**, and designated generally as delay line **40**. In **Figure 3**, only a portion of the delay line is shown, with additional stages being made in the identical manner to that shown in **Figure 3**. Delay line **40** consists primarily of delay elements **42, 44, 46**, which provide the required predetermined delays between a signal make available on input signal line **48** and the various tap outputs **50**. Delay element **42** provides the desired delay for tap T1, with the sum of delay elements **42** and **44** providing the desired delay for tap T2. Typically, each of the delay elements **42 - 46** provides the same delay time.

Before each delay element **42 - 46** is a corresponding AND gate **52, 54, 56**. The output of each delay element is used as an input to the AND gate preceding the following delay stage. The clock signal provided to the delay line **40** is input on signal line **48** into the first AND gate **52**. A flush signal is provided on signal line **54** to each of the AND gates **52 - 56** for purposes of quickly resetting the entire delay line as will be described below.

The delays in signal propagation caused by the AND gates **52 - 56** must be taken into account when determining the delays to be added by the delay elements **42 - 46**. Assume, for example, that the required delays to taps T1, T2, T3 are 10, 20, and 30 nanoseconds, respectively. Further, assume that each of the AND gates **52 - 56** adds a propagation delay of 2 nanoseconds to the signal. It is therefore necessary for the delay elements **42, 44, 46** to provide signal propagation delays of 8 nanoseconds each.

The flush signal connected to line **54** is normally high. When a clock cycle completes, the flush signal is brought low for a period of time which is at least as long as the delay of the longest delay element. When the flush signal goes low, the output of each of the AND gates **52 - 56** also goes low, causing a low signal to be input to each of the delay elements. After the delay caused by each delay element, its output goes low, feeding a low logical signal into the following AND gate. Thus, when the flush signal again goes high, the delay line remains reset.

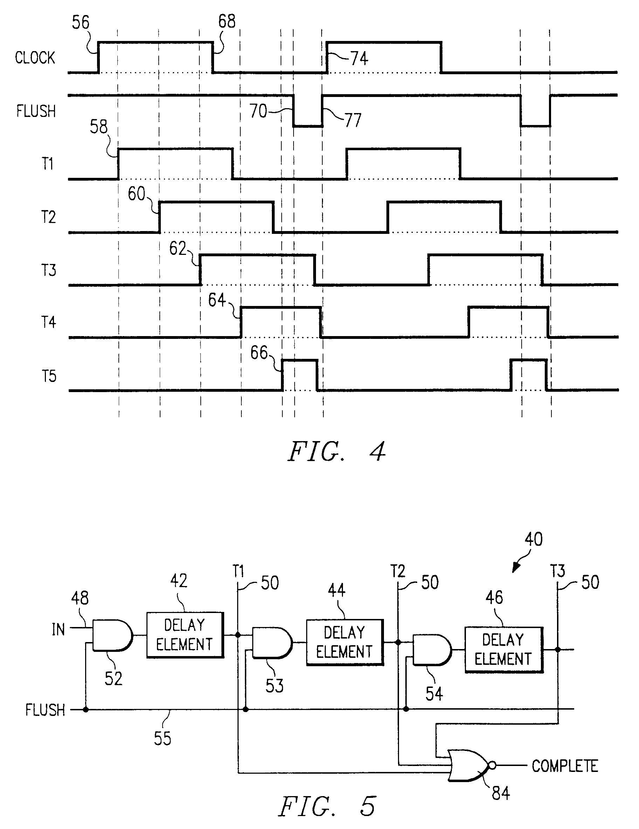

The timing diagram of **Figure 4** illustrates the operation of the circuit of **Figure 3**. The clock signal transitions high as shown by transition **56**, followed by the transition **58** of the first tap output. The flush signal remains high as described above. At each of the delay times defined by the physical properties of the delay line **40**, the remaining tap outputs T2 - T5 transition high as shown by transitions **60, 62, 64, 66**, respectively. Eventually, the clock cycle transitions low **68**. After the clock cycle completes, the flush signal transitions low **70** and stays low for a minimum time as described above. The flush signal then transitions high **72** prior to the beginning transition **74** of the next clock cycle.

As can be seen from the diagram of **Figure 4**, each of the output tap signals T1 - T5 returns low before the flush signal transitions high. This means that, at the beginning of the next clock cycle, all of the output taps have been reset to 0. Since every clock cycle begins with all of the output taps in a known state, the extra logic circuitry such as circuitry **16** shown in **Figure 1** is not required. All that is required is that a minimum delay be specified between successive clock cycles.

The flush signal itself is preferably generated from any signal which signals the end of a clock cycle. The flush signal will typically be initiated by a system signal available over a system bus, for example. If desired, the flush signal can be generated in part in response to one or more of the tap signals themselves combined with other clocking and control signals available in the system. The flush signal is typically provided from control circuitry separate from the delay line, and the precise circuitry used to generate the flush signal does not form a part of the present invention.

If desired, a signal can be generated to indicate when the flushing of the delay line **40** is completed. This can be easily accomplished by bringing all of the tap output signals to a logic gate which generates a signal only upon all of the delay elements being reset. An example is shown in **Figure 5** as a NOR gate **84**, which generates a high output when all of the delay elements go low. This signal can be used, if desired, to initiate the start of another clock cycle as soon as possible after the delay line has been reset in order to maximize system clock speed, or for various other control purposes as desired.

It will be appreciated by those skilled in the art that numerous variations of the circuitry described above may be implemented. For simplicity of description, all of the tap outputs have been illustrated as being reset to a low value. However, as known in the art, some of the tap outputs are normally high, and transition low as the clock signal propagates through the delay line. With a delay line of this type, either an inverter must be provided for such inverted tap outputs, or a different logic gate must be used before and after such delay element. If, for example, the tap output T2 of **Figure 3** is normally high, and transitions low in response to propagation of the clock signal through the delay line, gates **53** and **54** will be NAND gates instead of AND gates. Numerous other equivalent logic circuits may be utilized as will become apparent to those skilled in the art.

While the invention has been particularly shown and described with reference to a preferred embodiment, it will be understood by those skilled in the art that various changes in form and detail may be made therein without departing from the spirit and scope of the invention.

**Claims**

1. A flushable delay line, comprising:

   a delay line having a plurality of delay elements in series, wherein an input signal input to said delay line is transmitted through the delay elements;

   a plurality of output taps connected to the delay elements for providing timed output signals;

   a logic gate connected between an output of each of the delay elements in the delay line and its successor delay element; and

   a flush control input connected to each of said logic gates, wherein signals resetting the delay elements to known states are generated by said logic gates upon receipt of a flush signal.

2. The delay line of Claim 1, further comprising:

   an output logic gate connected to said output taps and generating a signal indicative of all of said output taps being reset to the known states.

3. A method for providing timed signals, comprising the steps of:

   in response to a clock signal, generating a sequence of timed output signals from delay elements of a delay line; and

   in response to a control signal, resetting all of the delay elements simultaneously to known states.

4. The method of Claim 3, wherein the delay elements are reset to the known state at the completion of a clock cycle, and before the initiation of a next clock cycle.

5. The method of Claim 3, wherein said resetting step comprises the steps of:

   between the delay elements in the line, logically combining the control signal with an output from a preceding delay element and sending a resulting signal to an input of a following delay element; and

   maintaining the control signal in a reset state for a time sufficient to ensure that the resulting signal has completely passed through each of the following delay elements.

6. A delay line, comprising:

   a plurality of delay elements connected in series;

   logic means connected between each delay element in the series, each of said logic means having a data input and a control input, wherein the data input is connected to an output of a preceding delay element, and having an output connected to an input of a following delay element, wherein a signal presented to the data input is transmitted to the output when the control input is in a first state, and wherein a preselected value is transmitted to the output when the control input is in a second state regardless of the value of the data input;

output signal taps connected to the outputs of said logic means; and

means for generating a flush control signal for connection to the control inputs of said logic means.

7.  The delay line of Claim 6, further comprising:

an output logic gate connected to said output signal taps and generating a signal indicative of all of said output signal taps being reset to known states.

FIG. 1
(PRIOR ART)

FIG. 2
(PRIOR ART)

FIG. 3

FIG. 4

FIG. 5